# EUROPEAN PATENT APPLICATION

(11) **EP 4 362 618 A1**
(43) Date of publication of application: **01.05.2024**
(21) Application number: 22203845.7
(22) Date of filing: 26.10.2022
(51) Int. Cl.: H05K 7/20

(54) **ELECTRONIC CONTROL UNIT**

(71) Applicant: MAHLE International GmbH, 70376 Stuttgart (DE)
(72) Inventor: Stolfa, Danijel, 5250 Solkan (SI); Verdev, Luka, 3320 Velenje (SI); Cimzar, Blaz, 4205 Preddvor (SI)

(57) **Abstract**

Electronic control unit (1) for an electrical machine of an electrically powered drive system, the electronic control unit (1) comprises at least one semiconductor board (2) having a plurality of power semiconductors (3), a baseplate (4) for dissipating heat generated in the electronic control unit (1), a holding bracket (6) attached to the baseplate (4), and resilient biasing means (8) arranged between the holding bracket (6) and the plurality of power semiconductors (3) for biasing the power semiconductors (3) towards the baseplate (4),wherein the holding bracket (6) comprises means for attaching the resilient biasing means (8) to the holding bracket.

## Description

### TECHNICAL FIELD

The invention relates to an electronic control unit according to the preamble of independent claim 1.

### BACKGROUND ART

It is generally known to bias heat generating semiconductor packages of an electronic control device towards a heat sink in order to effectively dissipate the heat away from the semi-conductor device via the heat sink.

A known prior art electronic control device is disclosed in KR20080099111A. This describes a box-shaped housing having openings on both sides and an aluminum heat sink attached to one opening of the housing. Semiconductor switching elements of the electronic control device are arranged in the housing and the semiconductor switching elements are pressed towards the heat sink via a leaf spring which is attached to the heat sink by a screw.

Means for clamping a semi-conductor to a heat sink is also disclosed in US5483103A. Again a leaf spring is attached to a heat sink with a screw, and the leaf spring biases the semiconductors, in this case via a leveler, towards the heat sink.

An electronic power inverter for an electrical machine is also known in EP3609066B1. The power inverter comprises a housing with a semiconductor board, a capacitor board, power terminals and phase terminal studs. The semi-conductor board is biased towards the heat exchanger plate by a pressing plate which is attached to the heat exchanger plate by screws, whereby a busbar guide plate, a capacitor board and a damping plate are arranged between the semi-conductor board and the pressing plate.

### SUMMARY

The electric control unit according to the invention as defined in claim 1 has the advantage that the semiconductors can be biased towards a cooling baseplate using only a low number of components, reducing assembly time.

This object is achieved according to the invention with an electronic control unit for an electrical machine, the electronic control unit comprising at least one semiconductor board having a plurality of power semiconductors, a baseplate for dissipating heat generated in the electronic control unit, a holding bracket attached to the baseplate, and resilient biasing means arranged between the holding bracket and the plurality of power semiconductors for biasing the power semiconductors towards the baseplate, wherein the holding bracket comprises means for attaching the resilient biasing means to the holding bracket.

By providing the holding bracket with means for attaching the resilient biasing means there is no need to attach each of the springs, which press the power semiconductors onto the baseplate, with screws to the cooling baseplate. Therefore, the number of parts can be reduced and assembly time can be improved. Also, space can be saved compared to prior art designs whereby each spring is attached by a screw to the baseplate.

The electronic control unit can in particular be an electric power inverter.

The resilient biasing means is advantageously provided by a plurality of leaf springs. The leaf springs are therefore attached to the holding bracket, which is attached to the baseplate. The leaf springs each comprise a central fixing part for attaching the leaf spring to the holding bracket and a plurality of biasing arms which extend integrally from the central fixing part and contact one of the power semiconductors or the semiconductor board for biasing the power semiconductors towards the baseplate.

As the power semiconductors are provided on a semiconductor board, they do not in a first embodiment contact the baseplate directly, however the pressing of the semiconductors presses in turn the semiconductor board against the baseplate and the contact between the power semiconductor, the semiconductor board and the baseplate is especially good in the area of the heat generating power semiconductors due to the leaf springs pressing on the power semiconductors.

In an alternative embodiment the power semiconductors could be arranged on the side of the semiconductor board facing the baseplate, whereby the leaf springs could be arranged to contact the semiconductor board in the area of the power semiconductors, and the power semiconductors would be in direct contact with the heat dissipating baseplate.

The leaf spring is preferably made out of sheet metal.

In a preferred embodiment the leaf springs each comprise at least four biasing arms which extend integrally from the central fixing part and contact respectively one of the semiconductors or the semiconductor board for biasing the semiconductors towards the baseplate. The leaf spring is preferably punched from a single piece of sheet metal. In this way each leaf spring can bias four power semiconductors towards the baseplate, therefore reducing the number of parts required.

The leaf springs can comprise at least one fixing opening in the central fixing part. Preferably two fixing openings are provided in each leaf spring. Providing two fixing openings enables a non-rotational positioning of the leaf spring with respect to the holding bracket.

The means for attaching the resilient biasing means to the holding bracket comprises holding pins which project from the holding bracket. Advantageously the holding bracket and the holding pins can be formed integrally. The holding bracket with the integral holding pins is preferably made out of aluminium, for example by high pressure die casting. Alternatively, the holding bracket with the integral holding pins can be made out of plastic for reduced weight, in this case it can be made by injection molding. The holding bracket with holding pins can therefore be manufactured in one molding step, in order to reduce assembly time.

The holding pins extend through the corresponding fixing openings in the leaf springs, and the leaf springs are attached to the holding bracket by deformation of the holding pins. The ends of the holding pins are preferably deformed such that the leaf spring is not rigidly fixed to the holding bracket, but instead is fixed in a floating manner. This has the advantage that the pins are not overstrained and the spring can position itself correctly on the holding bracket when the applying a biasing force onto the semiconductors.

The holding bracket is attached to the baseplate by a plurality of screws. For this purpose, the holding bracket can have through-holes through which the screws extend. The holding bracket can be attached by screws to the baseplate, wherein the screws can be located at the edges or corners of the bracket spaced from the power semiconductors. The fixing screws of the holding bracket are therefore not located between the power semiconductors. In this way the electronic control unit can be made more compact.

The holding bracket is provided with at least one, preferably at least two positioning holes for receiving respectively a plurality of first positioning pins which are fixed to or received in the baseplate. The first positioning pins can also extend through positioning holes in the at least one semiconductor board. The holding bracket can therefore be accurately positioned with respect to the baseplate and/or the at least one semiconductor board.

The holding bracket comprises a plurality of second positioning pins for positioning a logic control board in relation to the holding bracket. The pins can be made out of metal, preferably steel. The second positioning pins extend from the holding bracket in a direction away from the baseplate.

The baseplate is made from a thermally conductive metal, preferably aluminum, and can comprises pins or fins from improved heat dissipation.

### BRIEF DESCRIPTION OF THE DRAWINGS

Embodiments will now be described by way of example only with reference to the accompanying drawings, in which:
Figure 1 is a perspective view of an electronic control unit according to the invention
Figure 2 is an exploded view of the electronic control unit in fig. 1.
Figure 3 is a cross-sectional view of the electronic control unit according to the invention

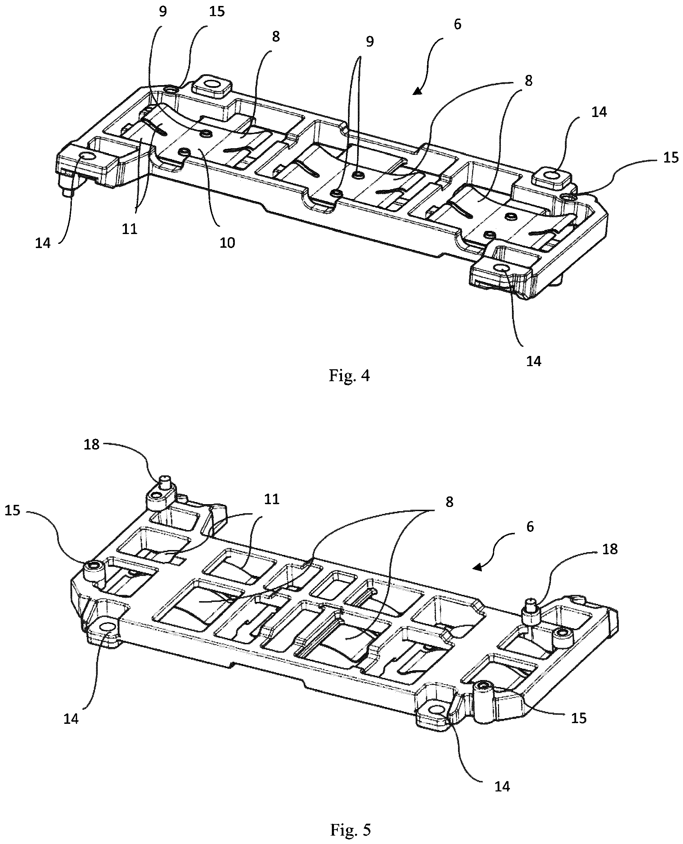

Figure 4 is a bottom perspective view of a holding bracket according to the invention
Figure 5 is a top perspective view of a holding bracket according to the invention
Figure 6 is a perspective view of a leaf spring according to the invention
Figure 7 is a cross-section of part of the holding bracket.

### DETAILED DESCRIPTION

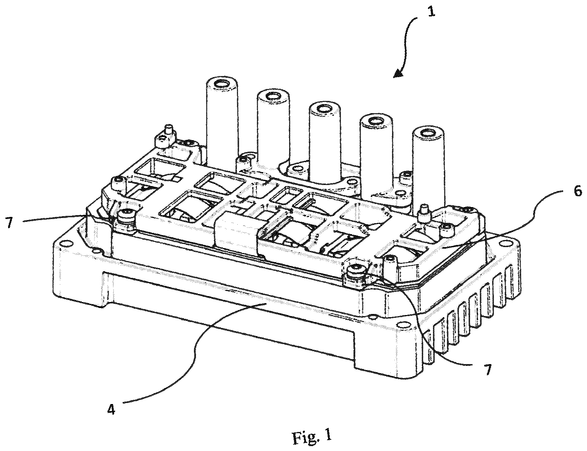

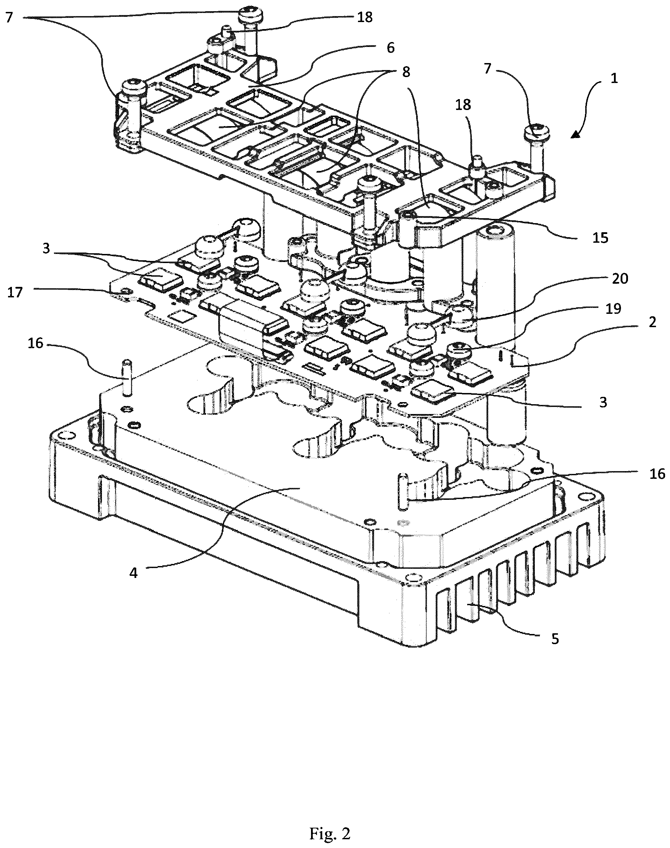

Figures 1 and 2 show an electronic control unit 1 for an electrical machine according to the invention. Figure 2 shows the electronic control unit 1 in an exploded view. The electronic control unit 1 can be for example an inverter unit for supplying three phase power to an electric motor. It could also be a converter unit for converting three phase power from a generator motor to DC power.

The electronic control unit 1 comprises at least one semiconductor board 2 having a plurality of power semiconductors 3. The power semiconductors generate heat when switching which must dissipated. For this purpose, a baseplate 4 for dissipating heat generated in the electronic control unit is provided. The baseplate 4 is preferably made of aluminum and can have a plurality of pins or fins 5 for improved cooling.

A holding bracket 6 is attached via screws 7 to the baseplate 4. Resilient biasing means in the form of leaf springs 8 are arranged between the holding bracket 6 and the plurality of power semiconductors 3 for biasing the power semiconductors 3 towards the baseplate, wherein the holding bracket 6 comprises means 9 for attaching the resilient biasing means 8 to the holding bracket 6.

By providing the holding bracket 6 with means 9 for attaching the leaf springs 8 there is no need to attach each of the springs, which press the power semiconductors onto the baseplate, with screws to the cooling baseplate.

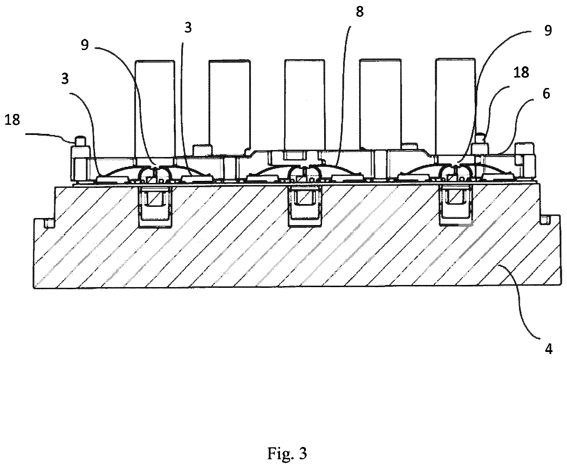

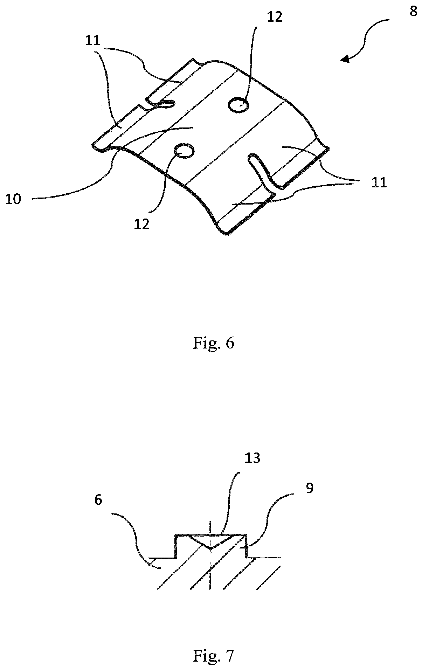

As can be best seen in figures 3 and 6, the leaf springs 8 each comprise a central fixing part 10 for attaching the leaf spring 8 to the holding bracket 6 and a plurality of biasing arms 11 which extend integrally from the central fixing part 10 and contact one of the power semiconductors 3 or the semiconductor board 2 for biasing the power semiconductors 3 towards the baseplate 4.

In the embodiment shown, the power semiconductors 3 are provided on the side of the semiconductor board 2 facing away from the baseplate 4 and therefore they do not contact the baseplate 4 directly, however the pressing of the semiconductors presses in turn the semiconductor board 2 against the baseplate 4 and the contact between the power semiconductor 3, the semiconductor board 2 and the baseplate 4 is improved in the area of the heat generating power semiconductors 3. There can also be a thermal heat transfer layer provided on the baseplate 4 in the area of the semiconductor board 2 to improve heat transfer away from the semiconductors 3.

In an alternative embodiment the power semiconductors 3 can be arranged on the side of the semiconductor board facing the baseplate 4, whereby the leaf springs 8 are then arranged to contact the semiconductor board 2 in the area of the power semiconductors, and the power semiconductors 3 are then in direct contact with the heat dissipating baseplate 4.

The leaf spring 8 is preferably made out of sheet metal, preferably punched out of a single sheet of metal. In the embodiment shown the leaf springs 8 each comprise four biasing arms 11 which extend integrally from the central fixing part 10 and contact respectively one of the semiconductors 3 for biasing the semiconductors 3 towards the baseplate 4. Each leaf spring 8 therefore presses four power semiconductors 3 towards the baseplate 4, therefore reducing the number of parts required. For a full bridge inverter with twelve power semiconductors 3 as shown in figures 1 and 2, only three such leaf springs 8 are required to bias all the semiconductors 3 towards the baseplate 4.

As shown in figure 6 the leaf springs 8 comprise two fixing openings 12 in the central fixing part 10 to position the leaf spring 8 with respect to the holding bracket 6. The holding bracket 6 comprises holding pins 9 which project from the holding bracket 6 in a direction towards the baseplate 4. The holding bracket 6 and the holding pins 9 are formed integrally out of aluminium, for example by high pressure die casting. The holding bracket 6 with holding pins 9 can therefore be manufactured in one molding step, in order to reduce assembly time. Alternatively the holding bracket 6 and the holding pins 9 can be formed integrally out of a plastic material for reduced weight, for example by injection molding.

The holding pins 9 extend through the corresponding fixing openings 12 in the leaf springs 8, and the leaf springs 8 are attached to the holding bracket 6 by deformation of the holding pins 9. The ends of the holding pins 9 are preferably deformed such that the leaf spring 8 is not rigidly fixed to the holding bracket 6, but instead is fixed in a floating manner. This has the advantage that the pins are not overstrained and the spring can position itself correctly on the holding bracket when the applying a biasing force onto the semiconductors. To facilitate the deformation of the holding pins 9 they are provided with a conical recess 13 in the free ends of the holding pin 9, as shown in figure 7.

As mentioned above, the holding bracket 6 is attached to the baseplate 4 by a plurality of screws 7. For this purpose, the holding bracket 6 has a plurality of through-holes 14 through which the screws 7 extend. The screws 7 can be located at the edges or corners of the bracket 6 spaced from the power semiconductors 3. The fixing screws 7 of the holding bracket are therefore not located between the power semiconductors 3. In this way the electronic control unit can be made more compact.

The holding bracket 6 is further provided with at least two positioning holes 15 for receiving respectively a plurality of first positioning pins 16 which are fixed to or received in holes in the baseplate 4. The first positioning pins 16 can also extend through positioning holes 17 in the semiconductor board 2. The holding bracket 6 can therefore be accurately positioned with respect to the baseplate 4 and/or the at least one semiconductor board 2.

The holding bracket also has a plurality of second positioning pins 18 for positioning a logic control board (not shown) in relation to the holding bracket 6. The second positioning pins 18 extend from the holding bracket 6 in a direction away from the baseplate 4. The logic control board is also arranged on the side of the holding bracket 6 facing away from the baseplate 4 and comprises corresponding positioning holes or openings to receive the pins 18. The pins 18 can be made out of metal, preferably steel.

### LIST OF REFERENCE NUMERALS

- 1.: Electronic control unit
- 2.: Semiconductor board
- 3.: Power semiconductors
- 4.: Baseplate
- 5.: Cooling fins
- 6.: Holding bracket
- 7.: Screws
- 8.: leaf spring
- 9.: Holding pin
- 10.: Central fixing part of leaf spring
- 11.: Biasing arm
- 12.: Fixing opening in leaf spring
- 13.: Conical recess
- 14.: Through-holes
- 15.: Positioning holes
- 16.: First positioning pins
- 17.: Positioning holes in semiconductor board
- 18.: Second positioning pins

## Claims

1. Electronic control unit (1) for an electrical machine of an electrically powered drive system, the electronic control unit (1) comprising at least one semiconductor board (2) having a plurality of power semiconductors (3), a baseplate (4) for dissipating heat generated in the electronic control unit (1), a holding bracket (6) attached to the baseplate (4), and resilient biasing means (8) arranged between the holding bracket (6) and the plurality of power semiconductors (3) for biasing the power semiconductors (3) towards the baseplate (4),
- wherein the holding bracket (6) comprises means for attaching the resilient biasing means (8) to the holding bracket.

2. Electronic control unit (1) according to claim 1, wherein the resilient biasing means (8) is provided by a plurality of leaf springs (8).

3. Electronic control unit (1) according to claim 2, wherein the leaf springs (8) each comprise a central fixing part (10) and a plurality of biasing arms (11) which extend integrally from the central fixing part (10) and contact one of the power semiconductors (3) or the semiconductor board (2) for biasing the power semiconductors (3) towards the baseplate (4).

4. Electronic control unit (1) according to claim 3, wherein at least one of the leaf springs (8) comprises at least four such biasing arms (11) which extend integrally from the central fixing part (10) and contact respectively one of the power semiconductors (3) or the semiconductor board (2) for biasing the power semiconductors (11) towards the baseplate (4).

5. Electronic control unit (1) according to claims 2 or 3, wherein the leaf springs (8) comprise at least one fixing opening (12) in the central fixing part (10).

6. Electronic control unit (1) according to one of the preceding claims, wherein the means for attaching the resilient biasing means (8) to the holding bracket (6) comprises holding pins (9) which project from the holding bracket (6), and the holding bracket (6) and the holding pins (9) are formed integrally.

7. Electronic control unit (1) according to claim 6, wherein the holding pins (9) extend through the corresponding fixing openings (12) in the leaf springs, and wherein the leaf springs (8) are attached floatingly to the holding bracket (6) by deformation of the holding pins (9).

8. Electronic control unit (1) according to claim 7, wherein at least one of the leaf springs (8) comprises two of said fixing openings (12) for positioning the leaf spring (8) with respect to the holding bracket (6).

9. Electronic control unit (1) according to one of the preceding claims, wherein the holding bracket (6) is attached to the baseplate (4) by a plurality of screws (7).

10. Electronic control unit (1) according to claim 9, wherein the screws (7) are located at the edges or corners of the bracket (6) spaced from the power semiconductors (3).

11. Electronic control unit (1) according to one of the preceding claims, wherein the holding bracket (6) is provided with at least two positioning holes (15) for receiving respectively a plurality of first positioning pins (16) which are fixed to or received in the baseplate (4).

12. Electronic control unit (1) according to one of the preceding claims, wherein the holding bracket (6) comprises a plurality of second positioning pins (18) extending in a direction away from the baseplate for positioning a control board in relation to the holding bracket (6).
